Europäisches Patentamt

European Patent Office

Office européen des brevets

(11) Publication number:

**0 232 146
A2**

(12) **EUROPEAN PATENT APPLICATION**

(21) Application number: 87300843.7

(22) Date of filing: 30.01.87

(51) Int. Cl.⁴: **G 03 G 19/00**

(30) Priority: 04.02.86 US 825926

(43) Date of publication of application:
12.08.87 Bulletin 87/33

(84) Designated Contracting States:
BE CH DE FR GB LI NL

(71) Applicant: **E.I. DU PONT DE NEMOURS AND COMPANY
1007 Market Street
Wilmington Delaware 19898 (US)**

(72) Inventor: **Palladino, John Vincent
436 Lincoln Avenue
Paulsboro New Jersey 08066 (US)**

**Stutheit, James Shelley
2302 Pennington Drive
Wilmington Delaware 19810 (US)**

(74) Representative: **Myerscough, Philip Boyd et al
J.A.Kemp & Co. 14, South Square Gray's Inn
London, WC1R 5EU (GB)**

(54) Improved resolution transfer of magnetic particles.

(57) A process is disclosed of forming a toned image on a substrate wherein a magnetically held toner image is formed on a magentic member employing disclosed values of magnetic structuring of the magnetic member and a toner having defined values of particle size and powder flow rate and the toner image is subsequently transferred to a substrate by pressure contact, thereby to achieve a dense coating of toner on the substrate.

**Description**

IMPROVED RESOLUTION TRANSFER OF MAGNETIC PARTICLES

BACKGROUND OF THE INVENTION

The present invention relates to a process of developing a high resolution image on a surface of a magnetic member with a dry magnetic toner. Background toner on the magnetic member is removed from the magnetic member prior to transfer of the toner to a substrate using heat and pressure. The present invention is particularly adapted to the transfer of magnetic toner which serves as a resist for the manufacture of printed circuit boards.

Edwards et al. U.S. Patent 4,2l6,282 discloses a process for reproducing graphic information by forming a magnetic image in a premagnetized layer of chromium dioxide with heating of the chromium dioxide to above its Curie point in selected areas. Uncharged ferromagnetic toner particles are applied uniformly to the chromium dioxide layer but adhere only to the magnetized areas. The toner particles are electrostatically transferred to a substrate. Alternating current coronas or other static neutralizing devices are used to neutralize unwanted charges.

Nacci et al. USP 4,388,39l discloses a process of forming an image of toner on a latent magnetic image in a magnetic member followed by direct transfer to a surface with coalescence of the toner. The surface which is not protected by the transferred toner is then permanently modified by etching or plating. A preferred toner contains a magnetic material and a binder of thermoplastic resin and plasticizer.

The present invention is an improvement over the process disclosed in Nacci USP 4,338,39l in the step of forming an image of magnetic toner on a magnetic member prior to transfer to a substrate.

SUMMARY OF THE INVENTION

The present invention is directed to a process of forming a magnetically held toner image on a magnetic member with excess background toner removed from the magnetic member followed by pressure contact transfer from the magnetic member to a substrate wherein the improvement comprises magnetic structuring the magnetic member in the range from 350 to 2000 magnetic lines per inch and employing a toner with a mean particle diameter in the range from 2 to 30 microns as measured by a Coulter Counter and a percent compressibility after 30 minutes of magnetization of not greater than 30% and wherein the toner on transfer to the substrate has a weight of at least l.0 milligrams per square centimeter.

DETAILED DESCRIPTION OF THE INVENTION

The present invention provides a toned image with high resolution. The transfer process forms a magnetically held image of multiple toner layers which is subsequently transferred to a substrate. The present invention is an improvement of the toner transfer process of USP 4,338,39l which is incorporated by reference herein.

Initially a magnetic member is employed which is conventionally called a printing plate. Generally the printing plate is made from chromium dioxide since such material has a low Curie point which facilitates selective demagnetization. The magnetic member initially is magnetized to obtain magnetic structuring in the range from 350 to 2000 magnetic lines per inch. A magnetic line contains one north pole and one south pole. A more preferred range is from 500 to l000 magnetic lines per inch. Thereafter the magnetic member is demagnetized in portions wherein magnetic toner should not adhere. A technique for obtaining an image pattern on this member is by heating portions of the member to above its Curie temperature, e.g., employing noncollimated or collimated light through artwork having transparent and nontransparent areas. Any technique for imaging the magnetic member can be employed, e.g., use of a laser programmed to scan the printing plate or a flash lamp.

Thereafter dry magnetic toner is applied to the imaged magnetic member. A toner having critical properties is essential in conjunction with a structured and imaged magnetic member to obtain a high resolution, dense multilayer toner image on a magnetic member. A high resolution toner image is essential in a preferred use of the toner image in making a printed circuit board, particularly with dense circuitry. The trend in making circuit boards is to compress the circuitry with narrow conductor paths and insulating spaces. As circuitry on a printing board becomes more dense, bridging of adjacent conductive areas can more easily occur which creates a need for high resolution in the application of magnetic toner. The toner image is preferably free of any pin holes which increase the chance of defects.

Conventional magnetic toner compositions can be employed including the toners disclosed in USP 4,335,39l. Such toner preferably contains magnetic material, binder and plasticizer with the first two components necessary in any toner to be employed. However it has been discovered that certain physical properties of the toner are critical.

It is necessary that relatively small toner particles be employed, i.e., particles having a mean particle diameter in the range from 2 to 30 microns as measured by a Coulter Counter. Use of Coulter Counter is a standard measurement technique frequently employed in particle size measurement. A preferred mean particle diameter is in the range from 3 to l5 microns.

It has been unexpectedly discovered that a key property of the toner is the fluidity of the toner, i.e., the toner must be extremely fluid which aids in obtaining improved resolution of the toner image. In the present disclosure, fluidity is expressed on the basis of percentage compressibility with this value determined after magnetization of the toner particles. The fluidity is expressed in accordance with the following formula:

$$\% \; C \; = \; \frac{100 \; (P-A)}{P}$$

wherein
C = compressibility
P = packed bulk density
A = aerated bulk density
The toner with any additive must be thoroughly mixed prior to measurement. An example of such mixing to ensure proper mixing with an additive introduced (e.g. introduction of silica in a preferred embodiment in the present invention) is with use of a Littleford FM-3 mixer. The low shear mixing blades are activated for five minutes followed by further mixing employing both high and low shear blades for an additional fifteen minutes.

The aerated bulk density (A) and packed bulk density can be measured using a Powder Characteristics Tester, Model 4 manufactured by Hosokowa Micromeritic Laboratory, Osaka, Japan. The procedure is stated in its Powder Characteristics Tester Operating Instructions, incorporated by reference herein. The general procedure on pages 9 to ll of the operating manual is as follows:

Aerated Bulk Density
     l. Fix the various attachments in the following order.
          (i) Place the stationary chute on pins at the front of the tester.
          (ii) The following parts should be mounted on a vibrating plate.
          Vibrating chute
          Spacer ring
          Screen (24 mesh)
          Screen cover
          Screen holding bar
     2. Place the pan directly under the stationary chute and set in place the bulk density measuring cup. The cup should be inserted in the pit which is made in the pan. Make sure the center of the measuring cup is in alignment with the center of the stationary chute.
     3. Using scoop gently put an adequate amount of the powder onto the screen.
     4. Set the selector switch to "VIB".
     5. The timer should be set for the maximum.
     6. Ascertain that the vibration amplitude rheostat is set at the "O" position.
     7. Push the start button.
     8. Increase the voltage on rheostat. The powder flow rate is controlled by the rheostat. As a standard, set the rheostat so that it will require approximately 20-30 seconds to heap the powder above the edge of cup. If the cup is filled too slowly or too quickly the results may vary considerably.
     9. When the powder heaps up in the cup, return the rheostat dial to "O" and then stop the vibration.
     l0. Using the scraper carefully remove the powder mound from the cup by drawing scraper across the top of the container. This should be done carefully in order to leave a flat surface of powder which is exactly level with the edge of the cup. When drawing the scraper across the cup be sure to have the scraper exactly vertical. When this has been done, weigh the container of powder carefully. The difference between the empty and full container weights will be the Bulk Density of the powder in grams per cc. (Note: as the container is exactly l00cc in volume the powder weight in grams should be divided by l00 to arrive at gms/cc).
     ll. Measure aerated bulk density 3 to 5 times and obtain an average figure.
Note: When the powder is free-flowing and of fairly coarse particle size, it will not be necessary to pass it through the vibrating screen. The powder can be gently poured into the cup by the scoop.

Packed Bulk Density
     l. Place the previously filled and leveled cup in the automatic tapping device and place the cup extension piece on top of the cup.
     2. Using the scoop fill to the top with the same powder.
     3. Turn the selector switch to the "TAP" position.
     4. Set the timer switch at l80 seconds for 60 cycle current.
     5. Push the start button, which will activate the tapping device.
     6. During the tapping period it is necessary to observe the level of the powder and if necessary add powder to the container extension so that the powder will not pack below the rim of the container.
     7. Tapping will be made l80 times and when the timer switch returns to the "O" position the tapping will cease automatically.
     8. When the tapping is finished, remove the container and its extension. With the scraper remove the powder which is above the edge of the container. Use the same care when leveling off the container as previously.

9. Weigh the container and the powder and the difference in the weight of the empty container and when filled with powder will be the Packed Bulk Density (Divide the weight of powder in grams by l00 to find the Packed Bulk Density in gms/cc).

Percent Compressibility After Magnetization

After the above text procedure, the toner was placed on a Hitachi Standard Developing Unit, Model 5-l540-C, manufactured by Hitachi Magnetics Corp., Edmore, MI 48829, containing a fixed outer sleeve and a rotating inner magnetic core. and allowed to rotate at a shaft speed of 90 rpm for 30 minutes. The toner was removed and the percent compressibility was determined using the measured aerated and packed bulk density values, and the formula provided earlier.

Generally to obtain the desired values of fluidity, it will be necessary to employ an additive in the proper amount. Toners having only a pigment with binder and plasticizer have been found to have poor flow characteristics. A preferred additive which has been found is silica. Generally a range from 0.05 to 2.0% by weight of the total composition is suitable and preferably a range from 0.2 to l.0%. However other additives which produce the desired fluidity as measured by the compressibility test can be employed. Although use of silica has been found to be beneficial to obtain the proper fluidity measurement, it is not the intent herein to be limited to incorporation of such material. It is the physical property obtained which is essential in the final composition rather than the additive incorporated.

The toner powder will have a compressibility value after 30 minutes of magnetization of not greater than 30%. A preferred range is from l5 to 30% and more preferably 20 to 27%.

The toner which is applied to the imaged magnetic member will comprise multilayers of the toner since a monolayer will result in pinholes. The present process allows the toner present on the surface of the magnetic member to have a weight of at least l.0 milligrams per square centimeter. Less dense coatings have a tendency to result in failure particularly in making a printed circuit board. Generally a preferred density will be in the range from l.5 to 4.0 milligrams per square centimeter.

Immediately after the transfer of toner to the magnetic member, excess toner is removed from areas where no toner is desired by use of a vacuum which removes toner by passage of air across the surface of the member. After application of the magnetic toner to the magnetic member which generally has a release coating such as a fluorinated polymer, the toner is transferred to a substrate by pressure contact. Generally the substrate is heated prior to toner contact which causes toner adhesion upon transfer.

In the present invention conventional operating conditions (e.g. conditions employed in the CIRTRAK® Transfer process) can be utilized with the stated improvements to obtain better resolution. To further illustrate the present invention, the following examples are provided with all parts and percentages by weight unless otherwise indicated.

Example 1

A CIRTRAK® Printing Plate which comprised an acicular chromium dioxide binder matrix on polyester film with a magnetic layer thickness of l0.5 microns, magnetically structured at 400 magnetic lines per inch and coated with a release coating poly(perfluoro-2-methylene-4-methyl-1,3 dioxolan)/vinylidene fluoride copolymer was thermally imaged with a pattern ranging from alternating l5 mil lines and l5 mil spaces to 6 mil lines and 6 mil spaces. The above described plate also contained images of commercial electronic circuitry with lines and spaces as small as 12 mils. Following thermal imaging, the plate was mounted on a commercial CIRTRAK® Printer.

Three magnetic toners were prepared for testing. The toners, all of the same composition, i.e. binder system and magnetic pigment, differed from one another with respect to the amount of fumed silica. Toner used in these experiments is composed of Atlac 382E polyester resin (ICI) (a propoxylated bisphenol-A, fumaric acid polyester having a tack point of 70°C and a liquid point of l99°C a molecular weight of 2500-3000 and a Tg of 58°C.), BASF Magnetic Pigment 345, triphenyl phosphate, ethylene vinylacetate copolymer (S.P. 82°C) and polyethylene wax (S.P. ll3°C).

Sample I contained 0.3% Tullanox 500 fumed silica. The toner was prepared by placing 60 lbs. of toner is a Littleford FM-3 mixer, then adding 0.l8 lbs. of fumed silica. The mixer hatch was closed and the machine low shear mixing blades or plows activated for a total of 5 minutes. Immediately following this cycle, the mixer high shear blades were energized and processing continued (high and low shear blades) for a total of l5 minutes. Toner was removed from the mixer and toner flow properties measured to determine % compressibility as follows:

|                | After 30 Minutes |
|----------------|------------------|
| Unmagnetized   | Of Magnetization |
| 24%            | 32%              |

Additional toners (Samples 2 and 3) were prepared, as described above, containing 0.6 and 0.8% fumed silica and the percentage compressibility of these toners was:

### Sample 2

|                | After 30 Minutes |
|----------------|------------------|
| Unmagnetized   | Of Magnetization |
| 23%            | 30%              |

### Sample 3

|                | After 30 Minutes |
|----------------|------------------|
| Unmagnetized   | Of Magnetization |
| 21%            | 27%              |

Each sample of toner had a mean particle diameter, as measured by a Coulter Counter in the range of l4 to l6 microns.

Samples were loaded into a CIRTRAK® magnetic decorator and prints made to copper panels. Minor excursion from standard or normal operating conditions were made during this process to determine their effect on print quality to maximize the process. Evaluation of the printed panels using Toner Sample I indicated a resolution no better than l5 mil lines and l5 mil spaces. Line quality on all patterns was judged poor.

The above printing procedure was repeated for Samples 2 and 3. Results were as follows:

|          | Lines and Spaces (mils) Capable of Being Resolved | Line Quality |
|----------|---------------------------------------------------|--------------|
| Sample 2 | 15/15                                             | Fair         |
| Sample 3 | 12/12                                             | Fair-Good    |

The weight of toner transferred from the magnetic member to the copper panel was 3.5 mg/cm$^2$. The above results clearly indicate improved print quality and resolution as toner flow properties were increased.

Example 2

A magnetic printing plate, similar in composition to that described in Example I, was structured at 400 magnetic lines/inch, and thermally imaged with the pattern indicated in Example I. Two additional plates were prepared containing 500 and 600 magnetic lines/inch.

A toner sample similar in flow properties to that of Sample 3 (from Example I) was loaded into the CIRTRAK® Decorator. Printings are made to panels under normal operating conditions and the panels evaluated for resolution capabilities. Results are indicated below:

| Magnetic Structuring (lines/inch) | Lines and Spaces (mils) Capable of Being Resolved | Weight of Toner on Panel (Milligrams per square centimeter) | Edge Quality |
|---|---|---|---|
| 400 | 12/12 | 3.5 | Fair-Good |
| 500 | 12/12 | 2.9 | Fair-Good |
| 600 | 8/10 | 2.6 | Good |

Example 3

Two toners of the same composition as previously tested, with different particle size distributions, were evaluated to determine their effect on print quality and resolution using magnetic printing plates containing various magnetic lines per inch. Toner composition was similar to the Sample 3 composition of Example I.

CIRTRAK®Printing Plates having compositions similar to that described in Example I but with a 4.5 micron thick with chromium dioxide/binder layer were magnetic structured at 600, 800, I,000 and I,200 magnetic lines per inch. Each plate, coated with a release coating similar to Example I was thermally imaged with a pattern designated "Auto Test" composed of alternating lines and spaces ranging from 5 mils (0.0127 cm) to 9 mils (0.0224 cm), in a machine direction (i.e., the direction of travel of the substrate) and transverse direction. A second pattern designated "Circle Pattern" was also employed. This pattern contained lines and spaces as follows:

| Lines Width (Mils) | Space Width (Mils) |
|---|---|
| 10 | 10 |
| 8 | 8 |
| 5.3 | 6.7 |
| 5.3 | 5.3 |
| 4 | 6.7 |
| 4 | 4 |

Toner Samples 4 and 5 possessed mean particle diameters of I4-I6 microns and II-I2 microns respectively and particle size distribution was 5-53 microns; and 3-28 microns respectively.

Powder flow, i.e., percentage compressibility values of the toner, was:

| Toner | Unmagnetized | After 30 Minutes Of Magnetization |
|---|---|---|
| Sample 4 | 21 | 27 |
| Sample 5 | 21 | 28 |

The experiment consists of loading toner Sample 5 into the CIRTRAK® magnetic decorator and mounting one of the imaged experimental printing plates on the print drum of a CIRTRAK® Printer and toning it.

Transfer of the toned image to a copper clad laminate was done under normal operating conditions. Vacuum level which controls the removal of toner in nonimage areas was 0.3 inches (0.762 cm) of water. Clearance of vacuum knife to drum was set at l2 mils.

Once a particular printing plate had been evaluated it was removed and another experimental printing plate mounted and testing resumed under similar conditions.

After evaluation of all experimental plates, the toner was removed and replaced with toner Sample 4; testing was continued in a manner similar to that described above for toner Sample 5.

Microscopic examination (l2X magnification) was used to evaluate printed panels for resolution and line quality. Machine and transverse direction lines on both the "Auto Test" and "Circle" patterns was rated Poor (P), Fair (F) or Good (G). In addition, if toner connected two adjacent lines, the letter (B) described this phenomenon. The term pin holes (PH) was used if resist lines contained holes which represent poor line quality. Generally, if resolution and line quality were rated F or F-G, this was considered to indicate commercial acceptance.

## TABLE I

| Sample Number | Wt. of Toner on Substrate (Milligrams per Square Centimeter) | Magnetic Structuring (lines/ inch) | M[a] or T | 5[b] | 6[b] | 7[b] | 8[b] | 9[b] |
|---|---|---|---|---|---|---|---|---|
| 5 | 2.5 | 600 | M | B | B | P | F-G | G |
|   |     |     | T | P | F | F | F-G | F-G |
| 4 | 2.5 | 600 | M | B | B | F | F | F-G |
|   |     |     | T | P | P-F | F | F | F |
| 5 | 2.2 | 800 | M | P-F | F-G | G | G | G |
|   |     |     | T | P | P-F | F | F-G | F-G |
| 4 | 2.2 | 800 | M | P-F | F | F | F-G | F-G |
|   |     |     | T | P | P | P-F | F | F |
| 5 | 1.7 | 1200 | M | P | F-G | F-G | F-G | G |
|   |     |     | T | P-F | F | F-G | F-G | F-G |
| 4 | 1.7 | 1200 | M | P | P | P-F | P-F | F |
|   |     |     | T | P | P-F | F | F | F |

(a) M = machine direction and T = transverse direction

(b) alternating lines and spaces in mils

7

### TABLE II

| Sample Number | Wt. of Toner on Substrate (Milligrams per Square Centimeter) | Magnetic structuring (lines/inch) | M(a) or T | 10/(c) 10 | 8/(c) 8 | 5.3/(c) 6.7 | 5.3/(c) 5.3 | 4/(c) 6.7 | 4/(c) 4 |
|---|---|---|---|---|---|---|---|---|---|
| | 2.5 | 600 | M | F–G | F–G | F | F | F | B |
| | | | T | P–F | P–F | P | P | P | B |
| | 2.5 | 600 | M | F–G | F–G | F–P | F | P | B |
| | | | T | F–P | P | P | P | P | B |
| | 2.2 | 800 | M | G | G | F–G | F–G | F | P |
| | | | T | F–G | F–G | F | F | F–P | P |
| | 2.2 | 800 | M | F | F | F–P | P | P | P |
| | | | T | P | P | P | P | P | P |
| | 1.7 | 1200 | M | F–G | F–G | F–G | F–G | F | F |
| | | | T | F–G | F–G | F–G | F–G | F–P | P–F |
| | 1.7 | 1200 | M | PH | PH | PH | PH | PH | PH |
| | | | T | PH | PH | PH | PH | PH | PH |

(a)   M = machine direction and T = transverse direction

(c)   lines in mils/spaces in mils

## Claims

1. A process of forming a toned image on a substrate wherein a magnetically held toner image is formed on a magnetic member, background toner is removed from the magnetic member and the toner image is transferred by pressure contact from the magnetic member to a substrate, characterised by forming the image by magnetic stucturing on the magnetic member in the range from 350 to 2000 magnetic lines per 2.54 cm (inch) and by employing a toner with a mean particle diameter of 2 to 30 $\mu$m as measured by a Coulter Counter and a percent compressibility after 30 minutes of magnetization of not greaater than 30%, the toner on transfer to the substrate having a weight of at least 1.0 milligrams per square centimeter.

2. A process according to claim 1 wherein the magnetic structuring is in the range from 500 to 1000 magnetic lines per 2.54 cm (inch).

3. A process according to claim 1 or 2 wherein the mean particle diameter is from 3 to 15 $\mu$m.

4. A process according to claim 1, 2 or 3 wherein the percent compressibility is from 15 to 30%.

5. A process according to claim 4 wherein the percent compressibility is from 20 to 27%.

6. A process according to any one of the preceding claims wherein the weight of toner on the substrate is from 1.5 to 4 milligrams per square centimeter.

7. A process according to any one of the preceding claims wherein the toner contains 0.05 to 2.0% by weight of silica.

8. A process according to claim 7 wherein the silica content of the toner is 0.2 to 1.0% by weight.

9. A process according to any one of the preceding claims which comprises the additional step of using the toned image on the substrate as a resist in the manufacture of printed circuit boards.